# EUROPEAN PATENT SPECIFICATION

(11) **EP 3 690 525 B1**
(45) Date of publication and mention of the grant of the patent: **24.08.2022**
(21) Application number: 18885031.7
(22) Date of filing: 30.11.2018
(51) Int. Cl.: G02F 1/1333, B29C 65/76

(54) **DISPLAY ASSEMBLY, DISPLAY AND TERMINAL**
ANZEIGEANORDNUNG, ANZEIGE UND ENDGERÄT
ENSEMBLE D'AFFICHAGE, DISPOSITIF D'AFFICHAGE ET TERMINAL

(30) Priority: 05.12.2017 CN 201711267927
(43) Date of publication of application: 05.08.2020
(73) Proprietor: Huawei Technologies Co., Ltd., Longgang District Shenzhen, Guangdong 518129 (CN)
(72) Inventor: WANG, Yuan, Shenzhen Guangdong 518129 (CN)
(74) Representative: Pfenning, Meinig & Partner mbB
(86) International application number: PCT/CN2018/118526
(87) International publication number: WO 2019/109866

(56) References cited:
- EP-A1- 2 158 077
- WO-A1-2016/135341
- WO-A1-2017/064925
- CN-A- 1 558 279
- CN-A- 104 698 681
- CN-A- 104 698 681
- JP-A- 2009 133 936
- US-A1- 2008 196 828
- US-A1- 2008 196 828
- US-A1- 2016 009 962

## Description

### TECHNICAL FIELD

The present invention relates to the field of display technologies, and in particular, to a display assembly, a display, and a terminal.

### BACKGROUND

In the existing display manufacturing field, to ensure reliability of an entire display, a display module is securely fastened to a casing by using an adhesive. Consequently, when the display needs to be repaired, the display module is rather difficult to dismantle.

At present, people mainly dismantle a display module based on a feature that an adhesive has relatively weak adhesiveness at a high temperature. The display module and an adhesive assembly or product are first put into a heater box, to heat an adhesive part directly on a heating platform or by using a heating rod and the like, and when a temperature of the adhesive reaches 70°C to 80°C, immediately pull the display module by using an adhesive disk or push the display module by using a tool, thereby implementing dismantlement of the display module. In such a manner of heating and forcedly dismantling the display module, the display module is quite easily deformed or damaged.

CN 104 698 681 A provides a liquid crystal module. The liquid crystal module comprises a display panel and a backlight module. The backlight module comprises a back plate and a glue frame. The back plate comprises a bottom plate and a side plate perpendicular to the bottom plate. The glue frame is arrange don the bottom plate and attached to the side plate. The glue frame comprises an upper glue frame body and a lower glue frame body. The upper glue frame body comprises a frame body and a first supporting block. The first supporting block is arranged on the inner surface of the frame body in the direction perpendicular to the frame body and is used for containing the display panel. The plane where the upper surface of the first supporting block is located is lower than the plane where the upper surface of the frame body is located. The length of the first supporting block is larger than that of the frame body. The lower glue frame body comprises a second supporting lock and a buckle protruding upwards from the second supporting block. The buckle is used for clamping the portion, protruding from the side face of the frame body, of the first supporting block so that the first supporting block can be clamped. The liquid crystal module is free of residual glue, yield is improved, and the detachment difficulty is lowered.

US 2008/196828 A1 describes adhesive compositions and methods of bonding and disbanding involve materials that include a polymer and an electrolyte, wherein the electrolyte provides sufficient ionic conductivity to enable a faradaic reaction at a bond formed between the composition and an electrically conductive surface, allowing the composition to disbond from the surface at room temperature. In some embodiments, the polymer component comprises or consists essentially of a thermoplastic polymer.

JP 2009 133936 A discloses a display module attached to a housing by an electrically conductive easy peel adhesive. The housing is provided with openings for electrically contacting two points on a same surface of the electrically conductive easy peel adhesive. When electrical power is supplied to the electrically conductive easy peel adhesive through the openings, the adhesive releases and the display panel is detached from the housing.

### SUMMARY

The present invention is to provide a display assembly, and a display according to the claims, so as to quickly dismantle a display module without damage during repairing of the display that becomes faulty.

The present invention provides a display assembly. A display includes a housing, an electrically conductive easy-peel adhesive, and a display module, where the housing includes an electric conductor attached to the electrically conductive easy-peel adhesive, the display module includes a conductive mounting surface in contact with the electrically conductive easy-peel adhesive, and the mounting surface is attached securely to the electric conductor by using the electrically conductive easy-peel adhesive; a first contact position is disposed on the electric conductor, and a second contact position is disposed on the mounting surface; and when the first contact position and the second contact position are connected to a power supply, the electrically conductive easy-peel adhesive is removed from the display module or the housing. A retaining direction of the electrically conductive easy-peel adhesive is able to be determined by changing a voltage direction of the power supply, so that the display module or the housing is quickly dismantled without damage.

The display module includes a display panel and a touch panel laminated onto the display panel, the display panel includes a display surface and a first lower surface opposite to the display surface, and the touch panel includes a second lower surface facing the display panel.

The mounting surface is a conductive body disposed on the first lower surface or the second lower surface, and the conductive body is electrically conductive. The housing may be partially or entirely a conductive area. To be specific, the electric conductor (which is electrically conductive) may be the entire housing, or may be a partial housing or a conductive layer located on a surface of the housing. In the present invention, the conductive body and the electric conductor that are electrically conductive are respectively disposed in the display module and the housing, so that upper and lower adhesive surfaces of the electrically conductive easy-peel adhesive are both conductive; and when the first contact position and the second contact position are simultaneously connected to the power supply, adhesiveness of the electrically conductive easy-peel adhesive is weakened, so as to dismantle the display module or the housing without damage.

The conductive body is a metal frame or a conductive adhesive layer, so that an adhesive surface between the electrically conductive easy-peel adhesive and the display module is electrically conductive.

The housing is made of a metallic material, and the electric conductor is the housing itself, that is, the entire housing is the electric conductor, so that the electrically conductive easy-peel adhesive and the housing are electrically conductive.

The first contact position is located on any surface of the housing, the second contact position is connected to a contact channel, and the contact channel is configured to provide a power connection for the second contact position. The first contact position and the second contact position conduct electricity for the upper and lower adhesive surfaces of the electrically conductive easy-peel adhesive, respectively.

The contact channel is a through hole that penetrates through the housing and the electrically conductive easy-peel adhesive. Different contact channels can be reserved depending on different requirements.

The electric conductor is the conductive adhesive layer disposed on the housing. The first contact position is connected to a first contact channel, the second contact position is connected to a second contact channel, the first contact channel provides a power connection for the first contact position, and the second contact channel provides a power connection for the second contact position. This helps conduct electricity for the upper and lower adhesive surfaces of the electrically conductive easy-peel adhesive.

The first contact channel is a through hole that penetrates through the housing reaching the conductive adhesive layer, and the second contact channel is a through hole that penetrates through the housing, the conductive adhesive layer and the electrically conductive easy-peel adhesive. Different contact channels can be reserved depending on different requirements.

When the conductive body is a conductive adhesive layer laminated onto the display module, the conductive body is disposed on the second lower surface, and adapts to assembly structures of different display assemblies. The housing is any one of a middle frame, a front housing, or a brace.

The conductive adhesive layer includes a metal film layer or a plastic film with a metallic material.

The present invention provides a display. The display includes the foregoing display assembly.

The present invention provides a terminal. The terminal includes the foregoing display, that is, includes the foregoing display assembly.

In an example not covered by the claimed invention but useful for understanding the present invention a display dismantlement method is provided. The display dismantlement method includes:
connecting a first contact position on a display module and a second contact position on an electric conductor respectively to a positive electrode and a negative electrode of a direct current power supply, so that a voltage is generated between a mounting surface of the display module and the electric conductor of the housing that are attached to an electrically conductive easy-peel adhesive, where the electric conductor includes the housing or a conductive adhesive layer disposed on a surface of the housing; and
removing the display module or the electric conductor from the electrically conductive easy-peel adhesive.

In the step of connecting a first contact position on a display module and a second contact position on an electric conductor respectively to a positive electrode and a negative electrode of a direct current power supply, so that a voltage is generated between a mounting surface of the display module and the electric conductor of the housing that are attached to an electrically conductive easy-peel adhesive, a retaining direction of the electrically conductive easy-peel adhesive is able to be determined by changing a voltage direction, so as to dismantle a damaged display module or housing. In this way, the electrically conductive easy-peel adhesive is retained on an intact housing or display module, thereby facilitating reuse for a plurality of times.

The display in the present invention uses a display module usage architecture in which the housing and the display module is attached by using the electrically conductive easy-peel adhesive, and the first contact position and the second contact position are respectively preset on surfaces of the conductive parts of the housing and the display module. When the display becomes faulty and needs to be repaired, the first contact position and the second contact position are simultaneously connected to the power supply to generate a voltage difference. In this case, a voltage difference is generated between the upper and lower adhesive surfaces of the electrically conductive easy-peel adhesive. Because adhesiveness of the electrically conductive easy-peel adhesive on an object surface varies with voltages, and the adhesiveness of the electrically conductive easy-peel adhesive is weakened fast at a specific voltage, the electrically conductive easy-peel adhesive is quite easily separated from an object surface at a positive electrode or a negative electrode. In this way, the display module or the housing is quickly dismantled without damage.

### BRIEF DESCRIPTION OF DRAWINGS

To describe technical solutions in embodiments of the present invention more clearly, the following briefly describes the accompanying drawings required for describing the embodiments or the prior art. Apparently, the accompanying drawings in the following description show merely some embodiments of the present invention, and a person of ordinary skill in the art may derive other drawings from these accompanying drawings without creative efforts.
FIG. 1 is a schematic structural diagram of a first embodiment of a display according to the present invention;
FIG. 2 is a schematic structural diagram of a second embodiment of a display according to the present invention;
FIG. 3 is a schematic structural diagram of a third embodiment of a display according to the present invention;
FIG. 4 is a schematic structural diagram of a fourth embodiment of a display according to the present invention;
FIG. 5 is a schematic structural diagram of a fifth embodiment of a display according to the present invention;
FIG. 6 is a schematic structural diagram of a sixth embodiment of a display according to the present invention; and
FIG. 7 is a schematic flowchart of a display dismantlement method according to an example not covered by the claimed invention but useful for understanding the present invention.

### DESCRIPTION OF EMBODIMENTS

The following clearly describes the technical solutions in the embodiments of the present invention with reference to the accompanying drawings in the embodiments of the present invention. Apparently, the described embodiments are merely some but not all of the embodiments of the present invention. All other embodiments obtained by a person of ordinary skill in the art based on the embodiments of the present invention without creative efforts shall fall within the protection scope of the present invention.

The present invention provides a display assembly. The display assembly is applied to a display, and the display includes but is not limited to a display of a mobile phone, a tablet computer, or a computer. The display uses a display module usage architecture in which a housing and a display module is attached by using an electrically conductive easy-peel adhesive. The display module or the housing can be quickly dismantled without damage during repairing of the display that becomes faulty. The display assembly includes the housing, the electrically conductive easy-peel adhesive, and the display module. The housing includes an electric conductor attached to the electrically conductive easy-peel adhesive. The display module includes a conductive mounting surface in contact with the electrically conductive easy-peel adhesive, and the mounting surface is attached securely to the electric conductor by using the electrically conductive easy-peel adhesive. A first contact position is disposed on the electric conductor, and a second contact position is disposed on the mounting surface. When the first contact position and the second contact position are connected to a power supply, the electrically conductive easy-peel adhesive is removed from the display module or the housing.

The housing in the present invention includes but is not limited to one of a middle frame, a front housing, or a brace. The display module includes but is not limited to one of a touch panel-liquid crystal display (TP-LCD, Touch Panel-Liquid Crystal Display) module, a touch panel-organic light-emitting diode (TP-OLED, Touch Panel-Organic Light-Emitting Diode) module, a touch panel (TP, Touch Panel), a liquid crystal display (LCD, Liquid Crystal Display), or an organic light-emitting diode (OLED, Organic Light-Emitting Diode).

The display assembly provided in the present invention uses the display module usage architecture in which the housing and the display module is attached by using the electrically conductive easy-peel adhesive, and the first contact position and the second contact position are respectively preset on the housing and the display module. When the display becomes faulty and needs to be repaired, the first contact position and the second contact position are simultaneously connected to the power supply to generate a voltage difference. In this case, a voltage difference is generated between upper and lower adhesive surfaces of the electrically conductive easy-peel adhesive. Because adhesiveness of the electrically conductive easy-peel adhesive on an object surface varies with voltages, and the adhesiveness of the electrically conductive easy-peel adhesive is weakened fast at a specific voltage, the electrically conductive easy-peel adhesive is quite easily separated from an object surface at a positive electrode or a negative electrode. In this way, the display module or the housing is quickly dismantled without damage. In addition, a retaining direction of the electrically conductive easy-peel adhesive is able to be determined by changing a voltage direction of the power supply. For example, when the display module in the display is damaged, the display module can be dismantled, to retain the electrically conductive easy-peel adhesive on the housing and attach the adhesive to a new display module; or when the housing in the display is damaged, the housing can be dismantled, to retain the electrically conductive easy-peel adhesive on the display module and attach the adhesive to a new housing. In this way, maintenance of the display is easy with low costs.

An example in which the housing is a middle frame and the display module is a touch panel-liquid crystal display module is used for detailed description in the embodiments of the present invention. The display module includes a display panel and a touch panel laminated onto the display panel. The display panel includes a display surface and a first lower surface opposite to the display surface, and the touch panel includes a second lower surface facing the display panel. The mounting surface is a conductive body disposed on the first lower surface or the second lower surface, and the conductive body is electrically conductive. Details are described by using the following embodiments.

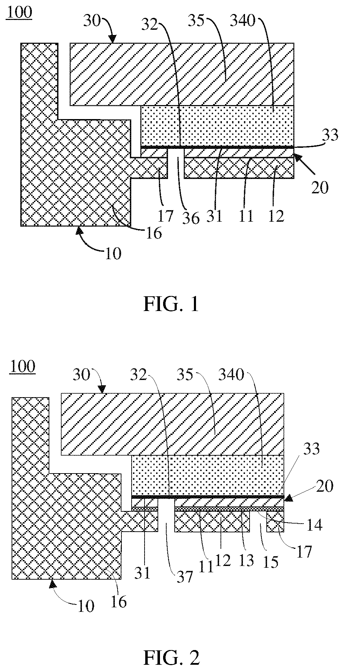

Referring to FIG. 1, in a first embodiment of the present invention, a housing is made of a metallic material, that is, a middle frame 10 is made of a metallic material. An electric conductor is the entire housing; a conductive body is a metal frame of a display module; and the metal frame is located on a first lower surface of the display module. Specifically, the middle frame 10 is made of a metallic material, and therefore the entire middle frame 10 may be used as the electric conductor. The middle frame 10 is provided with a mounting bracket 12, and a surface, facing the conductive body, of the mounting bracket 12 is construed as a surface 11 of the electric conductor. In this embodiment, the middle frame 10 includes a sidewall 16 and a beam 17, and the mounting bracket 12 is the beam 17 of the middle frame 10. The display module 30 includes a display panel 340, a touch panel 35 laminated onto the display panel, and the metal frame 33 that bears the display panel 340. The metal frame is a metal layer that covers a periphery of the display panel 340 and that faces away from a display surface, or may be a framework that surrounds a periphery of the display panel 340. The conductive body is the metal frame 33 of the display module 30, the metal frame 33 of the display module 30 is disposed on a surface of an electrically conductive easy-peel adhesive 20, and another surface of the electrically conductive easy-peel adhesive 20 is attached to the surface 11 of the mounting bracket 12. In this embodiment, a first contact position is disposed on any surface of the middle frame 10, that is, the first contact position may be located on a surface, facing away from the electrically conductive easy-peel adhesive 20, of the mounting bracket 12. A second contact position 32 is disposed on the metal frame 33, the second contact position 32 is connected to a contact channel 36, and the contact channel 36 provides a power connection for the second contact position 32. The contact channel 36 is a through hole that penetrates through the mounting bracket 12, the electrically conductive easy-peel adhesive 20, and reaches the metal frame 33. When the through hole is used as a contact channel to externally connect to a power supply, the external power supply can conduct electricity for a bottom of the display module 30 directly by using the through hole. During repairing of a display 100 that becomes faulty, an end of the external power supply is connected to the first contact position on the any surface of the middle frame 10, and another end is connected to the second contact position 32 through the contact channel 36. When a voltage difference is generated between the two ends, adhesiveness of the electrically conductive easy-peel adhesive 20 is weakened fast. In this way, the middle frame 10 or the display module 30 is quickly dismantled without damage.

Referring to FIG. 2, in a second embodiment of the present invention, different from the first embodiment, a housing is made of a non-metallic material, and an electric conductor is a conductive adhesive layer disposed on the housing, that is, a surface of the electric conductor in contact with an electrically conductive easy-peel adhesive is a surface of the conductive adhesive layer. Specifically, the housing is, for example, a middle frame. The middle frame 10 is made of a non-metallic material, a first conductive adhesive layer 13 is laminated onto a mounting bracket 12, the electric conductor is the first conductive adhesive layer 13, and a surface 11 of the first conductive adhesive layer 13 is in contact with the electrically conductive easy-peel adhesive 20. A conductive body of a display module 30 is a metal frame 33 of the display module 30, and the metal frame 33 of the display module 30 is disposed on a surface of the electrically conductive easy-peel adhesive 20. In this embodiment, a first contact position 14 is disposed on the first conductive adhesive layer 13, the first contact position 14 is connected to a first contact channel 15, the first contact channel 15 provides a power connection for the first contact position 14, and the first contact channel 15 is a through hole that penetrates through the middle frame 10 and reaches the firs1 conductive adhesive layer 13. A second contact position 32 is disposed on the metal frame 33, the second contact position 32 is connected to a second contact channel 37, the second contact channel 37 provides a power connection for the second contact position 32, and the second contact channel 37 is a through hole that penetrates through the mounting bracket 12, the first conductive adhesive layer 13 and the electrically conductive easy-peel adhesive 20, and reaches the metal frame 33. The through hole is used as a contact channel, to help an external power supply conduct electricity for the first conductive adhesive layer 13 of the middle frame 10 and the metal frame of the display module 30 by using the first contact channel 15 and the second contact channel 37.

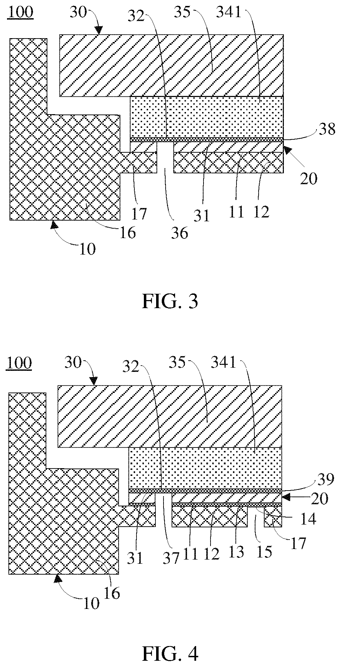

As shown in FIG. 3, in a third embodiment of the present invention, different from the second embodiment, a housing is made of a metallic material, and a conductive body is a conductive adhesive layer of a display module; and when the conductive body is the conductive adhesive layer laminated on the display module, the conductive body may be disposed on a first lower surface of the display module. Specifically, the housing is, for example, a middle frame. The middle frame 10 is made of a metallic material, and the entire middle frame 10 is an electric conductor. The display module 30 includes a conductive adhesive layer 38 laminated onto a display panel 341, the conductive adhesive layer 38 is disposed on a surface, facing away from a touch panel 35, of the display panel 341, the conductive body is the conductive adhesive layer 38, and the conductive adhesive layer 38 of the display module 30 is disposed on a surface of an electrically conductive easy-peel adhesive 20. In this embodiment, a surface, in contact with the conductive body, of the display panel 341 is not conductive. A first contact position is disposed on any surface of the middle frame 10, that is, the first contact position may be located on a surface, facing away from the electrically conductive easy-peel adhesive 20, of a mounting bracket 12. A second contact position 32 is disposed on the conductive adhesive layer 38, the second contact position 32 is connected to a contact channel 36, and the contact channel 36 provides a power connection for the second contact position 32. The contact channel 36 is a through hole that penetrates through the mounting bracket 12, the electrically conductive easy-peel adhesive 20, and reaches the conductive adhesive layer 38. When the through hole is used as a contact channel to externally connect to a power supply, the external power supply can conduct electricity for a bottom of the display module 30 directly by using the through hole.

Referring to FIG. 4, in a fourth embodiment of the present invention, different from the third embodiment, a housing is made of a non-metallic material; an electric conductor is a conductive adhesive layer disposed on the housing, that is, a surface in contact with an electrically conductive easy-peel adhesive is a surface of the conductive adhesive layer; and a conductive body is a second conductive adhesive layer of a display module. Specifically, the housing is, for example, a middle frame. The middle frame 10 is made of a non-metallic material, a first conductive adhesive layer 13 is laminated onto the middle frame 10, and the electric conductor is the first conductive adhesive layer 13. A surface 11 of the first conductive adhesive layer 13 is in contact with the electrically conductive easy-peel adhesive 20. The display module 30 includes a second conductive adhesive layer 39 laminated onto a display panel 341, the second conductive adhesive layer 39 is disposed on a first lower surface, facing away from a touch panel 35, of the display panel 341, the conductive body is the second conductive adhesive layer 39 laminated onto the display module 30, and the second conductive adhesive layer 39 of the display module 30 is located on a surface of the electrically conductive easy-peel adhesive 20. In this embodiment, a surface, in contact with the conductive body, of the display panel 341 is not conductive. A first contact position 14 is disposed on the first conductive adhesive layer 13, the first contact position 14 is connected to a first contact channel 15, the first contact channel 15 provides a power connection for the first contact position 14, and the first contact channel 15 is a through hole that penetrates through the middle frame 10 and reaches the first conductive adhesive layer 13. A second contact position 32 is disposed on the second conductive adhesive layer 39, the second contact position 32 is connected to a second contact channel 37, the second contact channel 37 provides a power connection for the second contact position 32, and the second contact channel 37 is a through hole that penetrates through a mounting bracket 12, the first conductive adhesive layer 13 and the electrically conductive easy-peel adhesive 20, and reaches the second conductive adhesive layer 39. An external power supply may conduct electricity both for the first contact position 14 and the second contact position 32 by using the through holes.

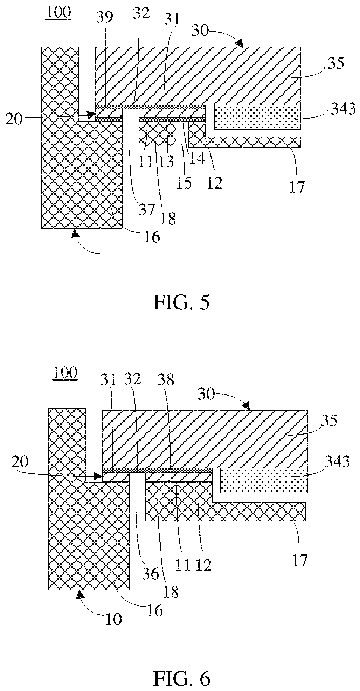

When a conductive body is a conductive adhesive layer laminated onto a display module, the conductive body may alternatively be disposed on a second lower surface of the display module. As shown in FIG. 5, in a fifth embodiment of the present invention, different from the fourth embodiment, a middle frame 10 further includes a step portion 18, a mounting bracket 12 is the step portion 18 of the middle frame 10, and a location of the step portion 18 is higher than that of a beam 17. In this embodiment, a housing is made of a non-metallic material, and the conductive body is a second conductive adhesive layer of the display module. Specifically, the housing is, for example, a middle frame. The middle frame 10 is made of a non-metallic material, a first conductive adhesive layer 13 is laminated onto the mounting bracket 12, an electric conductor is the first conductive adhesive layer 13, and a surface 11 of the first conductive adhesive layer 13 is in contact with an electrically conductive easy-peel adhesive 20. The display module 30 includes a second conductive adhesive layer 39 laminated onto a touch panel 35, the second conductive adhesive layer 39 is disposed on a second lower surface, facing a display panel 343, of the touch panel 35, the conductive body is the second conductive adhesive layer 39 laminated onto the display module, a mounting surface of the display module 30 is a surface, facing the electrically conductive easy-peel adhesive 20, of the second conductive adhesive layer 39, and the display module 30 is attached to the step of the middle frame 10 by using the second conductive adhesive layer 39. A surface, in contact with the conductive body, of the touch panel is not conductive. A first contact position 14 is disposed on the first conductive adhesive layer 13, the first contact position 14 is connected to a first contact channel 15, the first contact channel 15 provides a power connection for the first contact position 14, and the first contact channel 15 is a through hole that penetrates through the middle frame 10 and reaches the first conductive adhesive layer 13. A second contact position 32 is disposed on the second conductive adhesive layer 39, the second contact position 32 is connected to a second contact channel 37, the second contact channel 37 provides a power connection for the second contact position 32, and the second contact channel 37 is a through hole that penetrates through the mounting bracket 12, the first conductive adhesive layer 13 and the electrically conductive easy-peel adhesive 20, and reaches the second conductive adhesive layer 39. An external power supply may conduct electricity both for the first contact position 14 and the second contact position 32 by using the through holes.

Referring to FIG. 6, in a sixth embodiment of the present invention, different from the fifth embodiment, a housing is made of a metallic material, and a conductive body is a conductive adhesive layer of a display module. Specifically, the middle frame 10 is made of a metallic material, and therefore the entire middle frame 10 may be used as an electric conductor. The display module 30 includes a conductive adhesive layer 38 laminated onto a touch panel 35, the conductive adhesive layer 38 is disposed on a second lower surface, facing a display panel 343, of the touch panel 35, the conductive body is the conductive adhesive layer 38 laminated onto the display module, and a mounting surface of the display module 30 is a surface, facing an electrically conductive easy-peel adhesive 20, of the conductive adhesive layer 38. In this embodiment, a first contact position is disposed on any surface of the middle frame 10. For example, the first contact position may be located on a surface, facing away from the electrically conductive easy-peel adhesive 20, of a mounting bracket 12. A second contact position 32 is disposed on the conductive adhesive layer 38, the second contact position 32 is connected to a contact channel 36, and the contact channel 36 provides a power connection for the second contact position 32. The contact channel 36 is a through hole that penetrates through the mounting bracket 12, the electrically conductive easy-peel adhesive 20, and reaches the conductive adhesive layer 38. The through hole is used as a contact channel, to help an external power supply conduct electricity for the conductive adhesive layer of the display module 30 by using the contact channel 36.

A manner of laminating the conductive body that includes a metal frame or a conductive adhesive layer onto the display module and a manner of laminating the conductive adhesive layer onto the middle frame are not specifically limited in the present invention. For example, the lamination manner may be an adhesion manner by using an adhesive. The metal frame includes but is not limited to an iron frame or a copper foil. The conductive adhesive layer includes but is not limited to a metal film layer or a plastic film with a metallic material.

The present invention further provides a display. The display includes a backlight source and any display assembly according to Embodiments 1 to 6, where the backlight source provides a light source for the display assembly. The present invention provides a terminal. The terminal includes the foregoing display, that is, includes the foregoing display assembly.

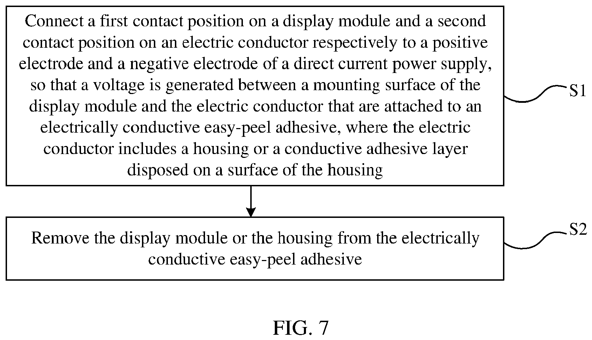

Referring to FIG. 7, an example not covered by the claimed invention but useful for understanding the present invention further provides a display dismantlement method, so as to quickly dismantle a display module or a housing in a display without damage. The display uses a display module architecture in which the housing and the display module is attached by using an electrically conductive easy-peel adhesive, upper and lower adhesive surfaces of the electrically conductive easy-peel adhesive are both conductive, a first contact position is preset on the housing, and a second contact position is preset on the display module. When the first contact position and the second contact position are simultaneously connected to a power supply, a conductive loop may be formed between the first contact position and the second contact position. The display described in this method is the display described in the foregoing embodiments. The display dismantlement method includes the following steps.

S1. Connect a first contact position on a display module and a second contact position on an electric conductor respectively to a positive electrode and a negative electrode of a direct current power supply, so that a voltage is generated between a mounting surface of the display module and the electric conductor that are attached to an electrically conductive easy-peel adhesive. A retaining direction of the electrically conductive easy-peel adhesive is able to be determined by changing a voltage direction. The electric conductor is a housing or a conductive adhesive layer disposed on a surface of the housing.

When the electric conductor is a housing, the first contact position is located on any surface of the housing, and the second contact position is connected to a contact channel. When the contact channel is a through hole that penetrates through the housing and the electrically conductive easy-peel adhesive, an end of the external power supply is connected to the first contact position on the any surface of the housing, and another end is connected to the second contact position through the through hole, so that a voltage is generated between the mounting surface of the display module and the electric conductor of the housing that are attached to the electrically conductive easy-peel adhesive, to change adhesiveness of the electrically conductive easy-peel adhesive.

When the electric conductor conducts electricity for some areas of a conductive adhesive layer, a first conductive adhesive layer is laminated onto the housing, the first contact position is located on the first conductive adhesive layer, the first contact position is connected to a first contact channel, and the second contact position is connected to a second contact channel. The first contact channel is a through hole that penetrates through the housing and the first conductive adhesive layer, and the second contact channel is a through hole that penetrates through the housing and the electrically conductive easy-peel adhesive. The external power supply directly conducts electricity for the first contact position and the second contact position by using the through holes, so that a voltage is generated between the mounting surface of the display module and the electric conductor that are attached to the electrically conductive easy-peel adhesive, to change adhesiveness of the electrically conductive easy-peel adhesive.

S2. Remove the display module or the housing from the electrically conductive easy-peel adhesive. In this step, because a retaining location of the electrically conductive easy-peel adhesive is determined by a direction of a direct current voltage, when the adhesiveness of the electrically conductive easy-peel adhesive is weakened, the housing or the display module may be removed from a surface of the electrically conductive easy-peel adhesive. For example, when the display module in the display is damaged, the display module can be dismantled, to retain the electrically conductive easy-peel adhesive on the housing and attach the adhesive to a new display module; or when the housing in the display is damaged, the housing can be dismantled, to retain the electrically conductive easy-peel adhesive on the display module and attach the adhesive to a new housing.

According to the display and the display dismantlement method not covered by the claimed invention but useful for understanding the present invention, the electrically conductive easy-peel adhesive is configured to attach to the display module and the housing, and the first contact position and the second contact position are respectively preset on the housing and the display module. When the display becomes faulty and needs to be repaired, because the adhesiveness of the electrically conductive easy-peel adhesive varies with voltages, the first contact position and the second contact position are simultaneously connected to the external direct current power supply, so that a voltage difference is generated between upper and lower adhesive surfaces of the electrically conductive easy-peel adhesive. The adhesiveness of the electrically conductive easy-peel adhesive changes, and therefore an object on the adhesive surfaces is easily removed from the surface of the electrically conductive easy-peel adhesive. In this way, the display module or the housing is dismantled without damage.

What is disclosed above is merely example embodiments of the present invention, and certainly is not intended to limit the scope of the claims of the present invention.

## Claims

1. A display assembly (100), comprising a housing, an electrically conductive easy-peel adhesive (20), and a display module (30), wherein the housing comprises an electric conductor attached to the electrically conductive easy-peel adhesive (20), the display module (30) comprises a conductive mounting surface in contact with the electrically conductive easy-peel adhesive (20), and the conductive mounting surface is attached securely to the electric conductor by using the electrically conductive easy-peel adhesive (20) therebetween; a first contact position (14) is disposed on the electric conductor, and a second contact position (32) is disposed on the conductive mounting surface; and
when the first contact position (14) and the second contact position (32) are connected to a power supply, the electrically conductive easy-peel adhesive (20) is removed from the display module (30) or the housing;
wherein the housing is made of a metallic material, and the electric conductor is the housing, the first contact position is located on any surface of the electric conductor, the second contact position (32) is connected to a contact channel (36), and the contact channel (36) is configured to provide a power connection for the second contact position (32); and the contact channel (36) is a through hole that penetrates through the housing and the electrically conductive easy-peel adhesive (20); or
wherein the electric conductor is a conductive adhesive layer (13) disposed on the housing, the first contact position (14) is connected to a first contact channel (15), the second contact position (32) is connected to a second contact channel (37), the first contact channel (15) provides a power connection for the first contact position (14), and the second contact channel (37) provides a power connection for the second contact position (32), ,the first contact channel (15) is a through hole that penetrates through the housing and reaches the conductive adhesive layer (13), and the second contact channel (37) is a through hole that penetrates through the housing , the conductive adhesive layer (13) and the electrically conductive easy-peel adhesive (20).

2. The display assembly (100) according to claim 1, wherein the display module (30) comprises a display panel (340) and a touch panel (35) laminated onto the display panel (340), the display panel (340) comprises a display surface and a first lower surface opposite to the display surface, and the touch panel (35) comprises a second lower surface facing the display panel (340); and
the mounting surface is a conductive body disposed on the first lower surface or the second lower surface, and the conductive body is electrically conductive.

3. The display assembly (100) according to claim 2, wherein the conductive body is a metal frame or a conductive adhesive layer.

4. The display assembly (100) according to claim 1 or 3, wherein when the electric conductor is a conductive adhesive layer (13) disposed on the housing or the conductive body is a conductive adhesive layer, the conductive adhesive layer comprises a metal film layer or a plastic film with a metallic material.

5. The display assembly according to any one of claims 1 to 4, wherein the housing is any one of a middle frame, a front housing, or a brace.

6. A display, comprising a backlight source and the display assembly according to any one of claims 1 to 5, wherein the backlight source provides a light source for the display assembly.

7. A terminal, comprising the display assembly according to any one of claims 1 to 6.

## Patentansprüche

1. Anzeigeanordnung (100), die ein Gehäuse, einen elektrisch leitfähigen, leicht abziehbaren Klebstoff (20) und ein Anzeigemodul (30) umfasst, wobei das Gehäuse einen elektrischen Leiter umfasst, der an dem elektrisch leitfähigen, leicht abziehbaren Klebstoff (20) befestigt ist, das Anzeigemodul (30) eine leitfähige Montageoberfläche in Kontakt mit dem elektrisch leitfähigen, leicht abziehbaren Klebstoff (20) umfasst und die leitfähige Montagefläche sicher an dem elektrischen Leiter durch Verwenden des elektrisch leitfähigen, leicht abziehbaren Klebstoffs (20) dazwischen befestigt ist; eine erste Kontaktstelle (14) auf dem elektrischen Leiter angeordnet ist und eine zweite Kontaktstelle (32) auf der leitfähigen Montageoberfläche angeordnet ist; und
wenn die erste Kontaktstelle (14) und die zweite Kontaktstelle (32) mit einer Stromversorgung verbunden sind, der elektrisch leitfähige, leicht abziehbare Klebstoff (20) von dem Anzeigemodul (30) oder dem Gehäuse entfernt wird;
wobei das Gehäuse aus einem metallischen Material hergestellt ist und der elektrische Leiter das Gehäuse ist, die erste Kontaktstelle auf einer beliebigen Oberfläche des elektrischen Leiters liegt, die zweite Kontaktstelle (32) mit einem Kontaktkanal (36) verbunden ist,
und der Kontaktkanal (36) dazu konfiguriert ist, eine Stromanschluss für die zweite Kontaktstelle (32) bereitzustellen; und der Kontaktkanal (36) ein Durchgangsloch ist, das das Gehäuse und den elektrisch leitfähigen, leicht abziehbaren Klebstoff (20) durchdringt; oder
wobei der elektrische Leiter eine leitfähige Klebstoffschicht (13) ist, die auf dem Gehäuse angeordnet ist, die erste Kontaktstelle (14) mit einem ersten Kontaktkanal (15) verbunden ist,
die zweite Kontaktstelle (32) mit einem zweiten Kontaktkanal (37) verbunden ist,
der erste Kontaktkanal (15) einen Stromanschluss für die erste Kontaktstelle (14) bereitstellt und
der zweite Kontaktkanal (37) einen Stromanschluss für die zweite Kontaktstelle (32) bereitstellt, der erste Kontaktkanal (15) ein Durchgangsloch ist, die das Gehäuse durchdringt und die leitfähige Klebstoffschicht (13) erreicht,
und der zweite Kontaktkanal (37) ein Durchgangsloch ist, das das Gehäuse, die leitfähigen Klebstoffschicht (13) und den elektrisch leitenden, leicht abziehbaren Klebstoff (20) durchdringt.

2. Anzeigeanordnung (100) nach Anspruch 1, wobei das Anzeigemodul (30) ein Anzeigefeld (340) und ein Berührungsfeld (35), das auf das Anzeigefeld (340) laminiert ist, umfasst, das Anzeigefeld (340) eine Anzeigeoberfläche und eine erste untere Oberfläche der Anzeigeoberfläche entgegengesetzt umfasst und das Berührungsfeld (35) eine zweite untere Oberfläche umfasst, die dem Anzeigefeld (340) zugewandt ist; und
die Montageoberfläche ein leitfähiger Körper ist, der auf der ersten unteren Oberfläche oder der zweiten unteren Oberfläche angeordnet ist und der leitfähige Körper elektrisch leitfähig ist.

3. Anzeigeanordnung (100) nach Anspruch 2, wobei der leitfähige Körper ein Metallrahmen oder eine leitfähige Klebstoffschicht ist.

4. Anzeigeanordnung (100) nach Anspruch 1 oder 3, wobei, wenn der elektrische Leiter eine leitfähige Klebstoffschicht (13) ist, die auf dem Gehäuse angeordnet ist oder der leitfähige Körper eine leitfähige Klebstoffschicht ist, die leitfähige Klebstoffschicht eine Metallfolie oder eine Kunststofffolie mit einem metallischen Material umfasst.

5. Anzeigeanordnung nach einem der Ansprüche 1 bis 4, wobei das Gehäuse eines von einem Mittelrahmen, einem vorderen Gehäuse oder einer Strebe ist.

6. Anzeige, die eine Hintergrundbeleuchtungsquelle und die Anzeigeanordnung nach einem der Ansprüche 1 bis 5 umfasst, wobei die Hintergrundbeleuchtungsquelle eine Lichtquelle für die Anzeigeanordnung bereitstellt.

7. Endgerät, das die Anzeigeanordnung nach einem der Ansprüche 1 bis 6 umfasst.

## Revendications

1. Ensemble d'affichage (100), comprenant un boîtier, un adhésif électriquement conducteur à décollement facile (20) et un module d'affichage (30), dans lequel le boîtier comprend un conducteur électrique fixé à l'adhésif électriquement conducteur à décollement facile (20), le module d'affichage (30) comprend une surface de montage conductrice en contact avec l'adhésif électriquement conducteur à décollement facile (20), et la surface de montage conductrice est fixée solidement au conducteur électrique à l'aide de l'adhésif électriquement conducteur à décollement facile (20) entre eux ; une première position de contact (14) est disposée sur le conducteur électrique, et une seconde position de contact (32) est disposée sur la surface de montage conductrice ; et
lorsque la première position de contact (14) et la seconde position de contact (32) sont connectées à une alimentation électrique, l'adhésif électriquement conducteur à décollement facile (20) est retiré du module d'affichage (30) ou du boîtier ; dans lequel le boîtier est constitué d'un matériau métallique, et le conducteur électrique est le boîtier, la première position de contact est située sur n'importe quelle surface du conducteur électrique, la seconde position de contact (32) est connectée à un canal de contact (36),
et le canal de contact (36) est configuré pour fournir une connexion électrique pour la seconde position de contact (32) ; et le canal de contact (36) est un trou traversant qui pénètre à travers le boîtier et l'adhésif électriquement conducteur à décollement facile (20) ; ou
dans lequel le conducteur électrique est une couche adhésive conductrice (13) disposée sur le boîtier, la première position de contact (14) est connectée à un premier canal de contact (15),
la seconde position de contact (32) est connectée à un second canal de contact (37),
le premier canal de contact (15) fournit une connexion électrique pour la première position de contact (14), et
le second canal de contact (37) fournit une connexion électrique pour la seconde position de contact (32), le premier canal de contact (15) est un trou traversant qui pénètre à travers le boîtier et atteint la couche adhésive conductrice (13),
et le second canal de contact (37) est un trou traversant qui pénètre à travers le boîtier, la couche adhésive conductrice (13) et l'adhésif électriquement conducteur à décollement facile (20) .

2. Ensemble d'affichage (100) selon la revendication 1, dans lequel le module d'affichage (30) comprend un panneau d'affichage (340) et un panneau tactile (35) stratifié sur le panneau d'affichage (340), le panneau d'affichage (340) comprend une surface d'affichage et une première surface inférieure opposée à la surface d'affichage, et le panneau tactile (35) comprend une seconde surface inférieure faisant face au panneau d'affichage (340) ; et
la surface de montage est un corps conducteur disposé sur la première surface inférieure ou la seconde surface inférieure, et le corps conducteur est électriquement conducteur.

3. Ensemble d'affichage (100) selon la revendication 2, dans lequel le corps conducteur est un cadre métallique ou une couche adhésive conductrice.

4. Ensemble d'affichage (100) selon la revendication 1 ou 3, dans lequel lorsque le conducteur électrique est une couche adhésive conductrice (13) disposée sur le boîtier ou le corps conducteur est une couche adhésive conductrice, la couche adhésive conductrice comprend une couche de film métallique ou un film plastique avec un matériau métallique.

5. Ensemble d'affichage selon l'une quelconque des revendications 1 à 4, dans lequel le boîtier est l'un quelconque d'un cadre central, d'un boîtier avant ou d'un renfort.

6. Dispositif d'affichage, comprenant une source de rétroéclairage et l'ensemble d'affichage selon l'une quelconque des revendications 1 à 5, dans lequel la source de rétroéclairage fournit une source de lumière pour l'ensemble d'affichage.

7. Terminal, comprenant l'ensemble d'affichage selon l'une quelconque des revendications 1 à 6.
